Europäisches Patentamt

European Patent Office

Office européen des brevets

(11) Publication number: 0 377 175
A2

# EUROPEAN PATENT APPLICATION

(21) Application number: 89123670.5

(22) Date of filing: 21.12.89

(51) Int. Cl.⁵: G03F 7/075

(30) Priority: 27.12.88 JP 327781/88

(43) Date of publication of application:
11.07.90 Bulletin 90/28

(84) Designated Contracting States:
DE FR GB NL

(71) Applicant: HITACHI, LTD.
6, Kanda Surugadai 4-chome
Chiyoda-ku Tokyo 101(JP)

Applicant: HITACHI CHEMICAL COMPANY
LTD.
1-1, 2-chome, Nishishinjuku Shinjuku-ku
Tokyo(JP)

(72) Inventor: Shiraishi, Hiroshi
128-195, Kawamachi
Hachioji-shi(JP)
Inventor: Ueno, Takumi
32-A302, Koyasumachi-2-chome
Hachioji-shi(JP)
Inventor: Hayashi, Nobuaki
8-6, Musashidai-5-chome Hidakamachi
Iruma-gun
Saitama-ken(JP)
Inventor: Fukuma, Emiko
28-35-607, Shirako-3-chome
Wako-shi(JP)
Inventor: Toriumi, Minoru
30-2B, Nishishichijo Yawatacho Shimogyo-ku
Kyoto-shi(JP)

(74) Representative: Patentanwälte Beetz sen. -
Beetz jun. Timpe - Siegfried -
Schmitt-Fumian- Mayr
Steinsdorfstrasse 10
D-8000 München 22(DE)

(54) Pattern forming composition and process for forming pattern using the same.

(57) A negative-type pattern (6) forming composition comprising (a) a silanol compound having one or more hydroxyl groups in average bonded to one silicon atom, and (b) an acid precursor, and if necessary, (c) an alkali-soluble resin, can give a pattern (6) with high sensitivity and high resolution.

F I G. 2

# PATTERN FORMING COMPOSITION AND PROCESS FOR FORMING PATTERN USING THE SAME

## BACKGROUND OF THE INVENTION

This invention relates to a material (composition) for forming a negative working resist particularly suitable for minute fabrication, and a process for forming a pattern using the same.

As silicon-containing resists usable for electron beam lithography excellent in minute fabrication, various materials have been proposed. Among them, a material having relatively high sensitivity is disclosed in Japanese Patent Unexamined Publication No. 60-80851 wherein a siloxane polymer or polysilsesquioxane bonded to cross-linkable functional groups is used. When such a material is exposed to actinic radiation such as electron beams, side chains are reacted to bring about cross-linking among polymers, resulting in insolubilization against a solvent. Thus, higher sensitivity can easily be obtained by previously enlarging the molecular weight of original polymer. But such a material is still insufficient for satisfying a requirement for both high sensitivity and high resolution at the same time. For example, when the molecular weight of the polymer is increased in order to obtain high sensitivity, the cross-linking density is undesirably lowered, resulting in swelling of pattern forming portions by a developing solution and deformation of pattern after development compared with a latent image. Further, an organic solvent should be used as the developing solution. This is not preferable from the viewpoint of saving resources, health, environmental pollution, etc.

On the other hand, U.S. Patent No. 4,722,881 discloses a radiation-sensitive composition comprising an admixture of a radiation or electron beam positive or negative resist and a mixture of cis-(1,3,5,7-tetrahydroxy)-1,3,5,7-tetraphenylcyclotetrasiloxane and a special polysilsesquioxane for forming a pattern excellent in resistance to oxygen RIE. But when such a composition is used for forming a negative working resist, the sensitivity is insufficient. Further, the silanol compound per se does not pertain to the reaction for forming the pattern but make the matrix resin alkali-soluble.

## SUMMARY OF THE INVENTION

It is an object of the present invention to provide a pattern forming composition containing a special silanol compound for forming a negative working resist with high sensitivity and high resolution, and soluble in an aqueous alkaline developer. It is another object of the present invention to provide a process for forming a pattern using such a material.

The present invention provides a composition for forming a negative working resist comprising

(a) a silanol compound having one or more hydroxyl groups in average bonded to one silicon atom, and

(b) an acid precursor capable of forming an acid when exposed to actinic radiation.

The present invention also provides a process for forming a pattern which comprises
forming an organic resin layer on a substrate,
forming a coating of the pattern forming composition mentioned above on the organic resin layer,
exposing the coating of pattern forming composition to actinic radiation,
developing the actinic radiation exposed coating with an aqueous alkaline developer to form a resist pattern, and
fabricating the organic resin layer using an etching medium containing oxygen plasma while using the resulting pattern as a mask to form a pattern.

## BRIEF DESCRIPTION OF THE DRAWINGS

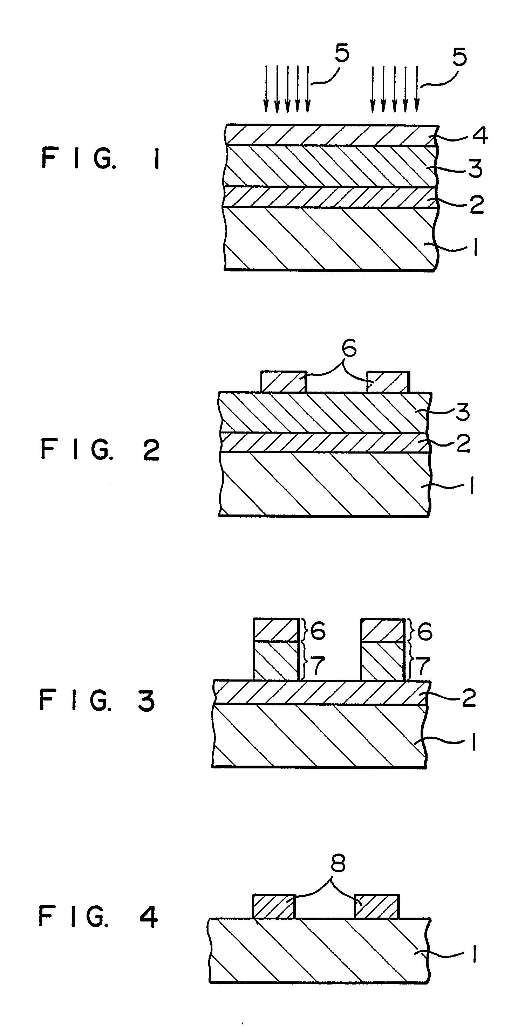

Figs. 1 to 4 are cross-sectional views explaining the process of the present invention.

## DESCRIPTION OF THE PREFERRED EMBODIMENTS

The composition used as a pattern forming material for forming a negative working resist comprises (a) a silanol compound having one or more hydroxyl groups in average bonded to one silicon atom, and (b) an acid precursor capable of forming an acid, preferably a strong acid, when exposed to actinic radiation, and if necessary, (c) an alkali-soluble resin.

The silanol compound (the component (a)) used in the present invention should have one or more hydroxyl groups in average bonded to one silicon atom. The words "in average" mean that the same effect can be obtained when one silicon atom has no hydroxyl group but another silicon atom has two hydroxyl groups, thus the two silicon atoms have two hydroxyl groups, one hydroxyl group being bonded to one silicon atom, in average.

When less than one hydroxyl group in average is bonded to one silicon atom, the resulting resist obtained from the composition becomes alkali-insoluble, and thus the effects of the present invention cannot be obtained.

Examples of the silanol compound are

chloromethylmethylsilanediol, methylvinylsilanediol, dichloromethyldimethylsilanol, chloromethyldimethylsilanol, ethylmethylsilanediol, ethoxymethylsilanediol, dimethoxymethylsilanol, trimethylsilanol, divinylsilanediol, methyl-3,3,3-trifluoropropylsilanediol, allylmethylsilanediol, dimethylvinylsilanol, 3-chloropropylmethylsilanediol, diethylsilanediol, methylpropylsilanediol, diethoxysilanediol, 3-cyanopropylmethylsilanediol, allyldimethylsilanol, 3-chloropropyldimethylsilanol, butylmethylsilanediol, dimethylpropylsilanol, dimethylisopropylsilanol, phenylsilanediol, diallylsilanediol, 3-cyanopropyl dimethylsilanol, methylpentylsilanediol, triethylsilanol, tert-butyldimethylsilanol, tri-ethoxysilanol, methylphenylsilanediol, methylphenylsilanol, cyclohexylmethylsilanediol, hexylmethylsilanediol, phenylvinylsilanediol, dimethylphenylsilanol, 6-methyldihydroxysilyl-2-norbornene, 2-methyldihydroxysilylnorbornene, 3-methacryloxypropylmethylsilanediol, heptylmethylsilanediol, dibutylsilanediol, allylphenylsilanediol, methylphenylvinylsilanol, 3-chloropropylphenylsilanediol, methyl-β-phenethylsilanediol, benzyldimethylsilanol, 2-(4-cyclohexenylethyl)-methylsilanediol, methyloctylsilanediol, tripropylsilanol, tert-butylphenylsilanediol, dimethyloctylsilanol, decylmethylsilanediol, diphenylsilanol, dihexylsilanediol, tributylsilanol, diphenylmethylsilanol, dodecylmethylsilanediol, diphenylvinylsilanol, trihexylsilanol, methyloctadecylsilanediol, dimethyloctadecylsilanol, tribenzylsilanol, docosylmethylsilanediol, 1,2-bis(methyldihydroxysilyl)-ethane, 1,1,3,3-tetramethyl-1,3-dihydroxysiloxane, 1,2-bis(dimethylhydroxysilyl)ethane, 1,4-bis-(dimethylhydroxysilyl)benzene, 1,3-dihydroxytetraisopropyldisiloxane, cis-(1,3,5,7-tetrahydroxy)-1,3,5,7-tetramethylcyclotetrasiloxane, diphenylsilanediol, triphenylsilanol, cis-(1,3,5,7-tetrahydroxy)-1,3,5,7-tetraphenylcyclotetrasiloxane, etc. Among them, preferable ones are diphenylsilanediol, triphenylsilanol, and cis-(1,3,5,7-tetrahydroxy)-1,3,5,7-tetraphenylcyclotetrasiloxane.

The silanol compound is preferably used in an amount of 5 to 90% by weight, more preferably 5 to 70% by weight, in the composition.

The component (a) can be a silicon compound capable of bringing about a condensation reaction by an acid catalyst. Examples of the silicon compound are those mentioned above as examples of the silanol compound, etc.

The silicon compound is preferably used in an amount of 5 to 90% by weight, more preferably 5 to 70% by weight, in the composition.

The silanol compound and the silicon compound are preferably solid at room temperature, with less volatility.

As the component (b), there is used an acid precursor capable of forming an acid, preferably a strong acid, when exposed to actinic radiation.

Examples of the actinic radiation are ultra violet rays, X-rays, electron beams, ion beams, excimer lasers (KrF excimer laser), etc.

Examples of the acid precursor are onium salts such as diphenyliodonium trifluoromethanesulfonate, triphenylsulfonium trifluoromethanesulfonate, etc.; sulfonic acid esters such as phenyl naphthalenesulfonate, p-nitrobenzyl 9,10-diethoxyanthracene-2-sulfonate, etc.; halogenated organic compounds such as tris(2,3-dibromopropyl) isocyanurate, etc.; 1,1-bis(p-chlorophenyl)-2,2,2-trichloroethane, 1,1-bis(p-methoxyphenyl)- 2,2,2-trichloroethane, 1,2,5,6,9,10-hexabromocyclododecane, 1,10-dibromododecane, 1,1-bis(p-chlorophenyl)-2,2-dichloroethane, 4,4'-dichloro-2-(trichloromethyl)benzhydrol, 1,1-bis-(chlorophenyl)-2,2,2-trichloroethanol, hexachlorodimethylsulfone, 2-chloro-6-(trichloromethyl)-pyridine, 0,0-diethyl-0-(3,5,6-trichloro-2-pyridyl)-phosphothioate, 1,2,3,4,5,6-hexachlorocyclohexane, N[1,1-bis(p-chlorophenyl)]-2,2,2-trichloroethylacetoamide, 2,2-bis(p-chlorophenyl)-1,1-dichloroethylene, tris(2,3-dichloropropyl) phosphate, tris(2-chloroethyl) phosphate; hexabromoethane, carbon tetrabromide, $\alpha,\alpha,\alpha$-trichloroacetophenone, $\omega,\omega,\omega$-tribromoquinaldine, $\alpha,\alpha,\alpha'$ = tetrabromo-o-xylene; halomethyl-s-tiazines such as 2,4-bis(trichloromethyl)-6-methyl-s-triazine, 2,4,6-tris(trichloromethyl)-s-triazine, 2,6-bis-(trichloromethyl)-6-p-methoxystyryl-s-triazine, etc.; onium salts such as non-substituted, symmetrically substituted or non-symmetrically substituted diaryliodonium salts, triarylsulfonium salts, and triarylselenonium salts, or substituted aryldiazonium salts, etc. As gegenanions for these compounds, there can be used strong Lewis acid anions such as tetrafluoroborate, hexafluoroantimonate, hexafluoroarsenate, hexafluorophosphate, trifluoromethanesulfonate, etc. It is also possible to use 4-thiophenoxyphenyl(diphenyl)sulphonium hexafluoroantimonate.

When the acid precursor produces a weak acid, there is a tendency to lower the effect as a catalyst for condensation reaction of silanol groups in the matrix resin. Therefore, the use of an acid precursor which can produce a strong acid or a super acid is preferable.

The acid precursor (b) is used in the composition preferably in an amount of 0.1 to 10% by weight. When the amount is less than 0.1% by weight, almost no effect is admitted. On the other hand, when the amount is more than 10% by weight, alkali solubility of non-exposed portions to the actinic radiation is remarkably lowered.

When the silanol compound or silicon compound is insufficient in film-forming properties by itself, an alkali-soluble resin is further used in order to improve properties such as film-forming properties, developing properties, etc.

As the alkali-soluble resin, there can be used novolak resins, phenolic resins, alkali-soluble resins cross-linkable by an acid catalyst, alkali-soluble resins containing a silicone. Examples of such resins are polycondensates or copolycondensates of aryl compounds having phenolic hydroxyl groups as substituents such as phenol novolak resins, o-cresol novolak resins, m-cresol novolak resins, m,p-cresol novolak resins, etc.; polymers or copolymers having phenolic hydroxyl groups at side chains such as poly(p-hydroxystyrene), brominated poly(p-hydroxystyrene), etc. These resins and polymers can be used alone or as a mixture thereof. It is also possible to preferably use aqueous alkali-soluble silicone resins such as poly-(p-hydroxybenzylsilsesquioxane), poly(p-hydroxybenzylsilane), etc. It is also possible to use poly-(styrene-maleic anhydride), polymethacrylate, polyacrylate, etc. When the resin matrix by itself is acidic, it can be used in a field wherein the shelf life is not a problem.

The alkali-soluble resin can preferably be used in an amount of 25 to 95% by weight, more preferably 30 to 95% by weight based on the weight of the composition.

The composition for forming a pattern of the present invention has high sensitivity by itself and is excellent in resolution, so that it can form a pattern by a single layer of coating according to a conventional method for forming a photoresist. It is also possible to form a pattern by a so-called double-layer resist method. In this case, the thickness of the upper resist layer is preferably 0.3 to 2 μm and that of the lower layer is 1.0 to 4.0 μm which should have sufficient thickness to cover (or smooth) the substrate surface topography (or unevenness). In this case, the silicon atom content in the upper resist layer is preferably 8% by weight or more. When the silicon atom content is less than 8% by weight, the resist properties against oxygen plasma are undesirably lowered. The silicon atom content means the total content of silicon atoms contained in the composition, that is, the amount of silicon atoms in the silanol compound (a) or the silicon compound (a) plus silicon atoms in the alkali-soluble resin when a silicon atom-containing resin is used.

According to the present invention, a pattern is produced by

forming an organic resin layer on a substrate,
forming a coating of the pattern forming composition mentioned above on the organic resin layer,
exposing the coating of pattern forming composition to actinic radiation,
developing the actinic radiation exposed coating with an aqueous alkaline developer to form a pattern, and
fabricating the organic resin layer using an etching medium containing oxygen plasma while using the resulting pattern as a mask.

In the above-mentioned process, the silanol compound (a) having one or more hydroxyl groups in average bonded to one silicon atom, said silanol compound having high affinity, to an aqueous alkali solution, brings about a condensation reaction by the acid catalyst and changes easily to a water-insoluble silicon compound.

When the silicon compound capable of bringing about a condensation reaction by an acid catalyst is used, it changes to a water-insoluble silicon compound.

As the organic resin for forming the organic resin layer on the substrate, there can be usually used a hard-baked conventional positive photo resist insoluble to the coating solvent of the pattern forming composition mentioned above.

As the substrate, there can be used a semiconductor element, a wiring metal such as aluminum, an insulator such as silicon oxide, etc.

The coating containing the silanol compound or the silicon compound and the acid precursor formed on the organic resin layer is then subjected to an image-wise exposure to actinic radiation for forming a latent image. The silanol compound or the silicon compound on the exposed portions brings about the condensation reaction using the acid induced and formed by the exposure to give a water-insoluble silicon compound. In this case, it is effective to use some treatment such as heating to accelerate the condensation reaction. The portions not exposed to actinic radiation do not generate an acid, so that no condensation reaction proceeds, in other words, high affinity to an alkali aqueous solution is maintained. In contrast, the exposed portions bring about the condensation reaction to form a water-insoluble component and to greatly reduce the alkali-solubility of the coating of pattern forming composition. Thus, by applying an alkali aqueous solution as a developer, a negative pattern is formed.

Since the above-mentioned condensation reaction is a catalytic reaction, the irradiation dose of actinic radiation for producing the acid is not required so much, so that high sensitivity can be obtained. Further, since water-insolubility of the product obtained by the condensation reaction is applied, there is no fear of causing swelling which deteriorates the resolution during the development, resulting in producing high resolution. In addition, since the silicon content of the pattern forming portions is not lowered by the developing treatment and the like, the resulting pattern can function as a mask for oxygen plasma.

In the above-mentioned process, the conditions of exposing to actinic radiation, the conditions for development, and the conditions for fabrication of the organic layer are not special ones and conventional conditions can be used.

The present invention is illustrated by way of the following Examples, in which all parts and percents are by weight, unless otherwise specified.

Example 1

A solution having a solid content of about 20% was prepared by dissolving 5 parts of m-cresol novolak resin, 5 parts of cis-(1,3,5,7-tetrahydroxy)-1,3,5,7-tetraphenylcyclotetrasiloxane and 0.1 part of triphenylsulfonium trifluoromethanesulfonate in Cellosolve acetate and filtered using a Tefron membrane filter having a pore diameter of 0.2 μm to give a resist solution.

Figs. 1 to 4 illustrate one example of pattern forming process according to the present invention using the above-mentioned resist solution. As shown in Fig. 1, an aluminum film 2 to be fabricated (1 μm thick) for forming a wiring layer was formed on a semiconductor substrate 1, and an organic resin layer 3 was formed on the aluminum film 2. Using the resist solution, a silanol-containing resist layer 4 of 0.5 μm thick was formed on the organic resin layer 3. Using an electron beam imaging apparatus, electron beams 5 were irradiated imagewisely to give a wiring pattern. The organic resin layer 3 of 1.8 μm thick was obtained by coating a positive-type photoresist (OFPR-800, mfd. by Tokyo Ohka Kogyo Co., Ltd.) and heating at 230°C for 30 minutes. The silanol-containing resist layer 4 was obtained by spin coating the resist solution on the organic resin layer 3 and the heating at 80°C for 10 minutes. The irradiation of electron beams was carried out at an accelerating voltage of 30 kV and an irradiation dose of 3.5 μC/cm². The substrate wherein a latent image of wiring pattern was formed by the electron beams 5 as shown in Fig. 1 was subjected to a heat treatment at 105°C for 10 minutes to accelerate the condensation reaction of the silanol compound in the latent image portion in the resist layer 4.

Fig. 2 shows a state wherein the resist layer 4 was developed using a developing solution containing an aqueous solution of 1.2% tetramethylammonium hydroxide after the above-mentioned heat treatment to form an upper resist pattern 6. The developing time was 30 seconds. The resulting upper resist pattern 6 had a remarkably good cross-sectional shape of rectangle.

Fig. 3 shows a state wherein a lower pattern 7 was obtained by etching of the organic resin layer 3 with oxygen plasma by reactive ion etching in accordance with the upper resist pattern 6 using the substrate as shown in Fig. 2. The upper resist pattern 6 was hardly etched and transferred to the organic resin layer in high precision.

Fig. 4 shows a state wherein an aluminum wiring pattern 8 was formed on the semiconductor substrate 1 obtained by etching the aluminum film 2 by reactive ion etching containing chlorine in accordance with the lower pattern 7, and removing the upper resist pattern 6 and the lower pattern 7, now becoming unnecessary, with plasma containing fluorine and oxygen first, and plasma containing oxygen in the next place.

The resulting wiring pattern was remarkably good in shape. The sensitivity and the resoltuion were satisfactorily good.

Example 2

A resist solution having a solid content of about 20% by weight was prepared in the same manner as described in Example 1 by dissolving 5 parts of m,p-cresol novalak resin, 4.5 parts of cis-(1,3,5,7-tetrahydroxy)-1,3,5,7-tetraphenylcyclotetrasiloxane, 0.5 part of diphenylsilanediol, and 0.1 part of triphenylsulfonium trifluoromethanesulfonate in Cellosolve acetate.

Good aluminum wiring pattern was obtained using the resist solution thus obtained in the same manner as described in Example 1 except for using the electron beam irradiation dose of 2.5 μC/cm², and an aqueous solution of 2.38% of tetramethylammonium hydroxide as the developing solution with the developing time of 100 seconds.

The sensitivity and the resolution were satisfactorily good.

Example 3

A resist solution having a solid content of about 20% by weight was prepared in the same manner as described in Example 1 by dissolving 4.5 parts of m,p-cresol novolak resin, 0.5 part of methylol resin (Methylon-75108, mfd. by BTL Speciality Resin Corp. in U.S.), 4.5 parts of cis-(1,3,5,7-tetrahydroxy)-1,3,5,7-tetraphenylcyclotetrasiloxane, 0.5 part of diphenylsilanediol, and 0.1 part of triphenylsulfonium trifluoromethanesulfonate in Cellosolve acetate.

Good aluminum wiring pattern was obtained using the resist solution thus obtained in the same manner as described in Example 1 except for using the electron beam irradiation dose of 1.5 μC/cm². Further, as a developing solution for the upper silanol-containing resist layer, an aqueous solution of 2.38% tetramethylammonium hydroxide was used with the developing time of 200 seconds.

The sensitivity and the resolution were satisfactorily good.

Example 4

A resist solution having a solid content of about 20% by weight was prepared in the same manner as described in Example 1 by dissolving 8 parts of m,p-cresol novolak resin, 2 parts of diphenylsilanediol and 0.4 part of triphenylsulfonium trifluoromethanesulfonate in Cellosolve ethyl acetate.

The resist solution was spin coated on a semiconductor substrate and heat treated at 80°C for minutes to give a coated film of 1.2 $\mu$m thick. After irradiating with electron beams at an accelerating voltage of 30 kV and irradiation dose of 1.2 $\mu C/cm^2$ followed by heat treatment at 80°C for 10 minutes, development was carried out using a developing solution of 2.38% of tetramethylammonium hydroxide for 300 seconds to give a pattern having a degree of resolution of line/space of 0.5 $\mu$m. The sensitivity and the resolution were satisfactorily good.

Examples 5 and 6

The process of Example 1 was repeated except for using an alkali-soluble resin containing silicon atoms (Example 5) or poly(p-hydroxybenzylsilsesquioxane) (Example 6) in place of the alkali-soluble novolak resin.

The resistance to the oxygen plasma etching at the time of transferring the upper resist pattern to the lower layer in the double-layer resist method in Example 1 was excellent in both Examples 5 and 6.

The resistance to the oxygen plasma etching depended on the silicon atom content in the upper silanol-containing resist layer. Good transferring properties were obtained when the silicon atom content was 8% or more, more preferably 10% or more.

Example 7

The process of Example 1 was repeated except for using ultraviolet rays or X-rays in place of the electron beams.

The same good results as obtained in Example 1 were obtained.

Example 8

The process of Example 1 was repeated except for using as the acid precursor diphenyliodonium trifluoromethanesulfonate, triphenylsulfonium p-toluenesulfonate, phenyl naphthalenesulfonate, p-nitrobenzyl 9,10-diethoxyanthracene-2-sulfonate or tris(2,3-dibromopropyl) isocyanurate in place of triphenylsulfonium trifluoromethanesulfonate.

The same good results as obtained in Example 1 were obtained.

As mentioned above, the pattern forming composition of the present invention can give a pattern with high sensitivity and high resolution.

**Claims**

1. A composition for forming a negative working resist (4) comprising

(a) a silanol compound having one or more hydroxyl groups in average bonded to one silicon atom, and

(b) an acid precursor capable of forming an acid when exposed to actinic radiation (5).

2. A composition according to Claim 1, which further comprises

(c) an alkali-soluble resin.

3. A composition according to Claim 1, wherein the silanol compound is contained in an amount of 5 to 70% by weight.

4. A composition for forming a negative working resist (4) comprising

(a) a silicon compound capable of bringing about a condensation reaction by an acid catalyst, and

(b) an acid precursor capable of forming an acid when exposed to acitinic radiation (5).

5. A composition according to Claim 4, which further comprises

(c) an alkali-soluble resin.

6. A composition according to Claim 4, wherein the silicon compound is contained in an amount of 5 to 70% by weight.

7. A process for forming a pattern which comprises

forming an organic resin layer (3) on a substrate, (1; 1,2)

forming a coating (4) of the composition of claim 1 or 4 on the organic resin layer (3),

exposing the coating (4) of the composition of claim 1 or 4 to actinic radiation,

developing the actinic radiation exposed coating (4) with an acqueous alkali developer to form a resist pattern (6), and

fabricating the organic resin layer (3) using an etching medium containing oxygen plasma while using the resulting pattern (6) as a mask to form a pattern (7).

8. A process according to claim 7, wherein the substrate comprises a semiconductor substrate (1) covered with an aluminun film, (2), and, after forming said pattern (6, 7) said aluminum film (2) is etched by reactive ion etching to form an aluminum wiring pattern (8) in accordance with the organic resin pattern (7).

9. A process according to claim 8, wherein, after forming said aluminum wiring pattern (8), the resist pattern (6) and the organic resin pattern (7) are removed with plasma containing fluorine and oxygen first, and plasma containing oxygen thereafter.

FIG. 1

FIG. 2

FIG. 3

FIG. 4